## Europäisches Patentamt

## European Patent Office

## Office européen des brevets

(11) Veröffentlichungsnummer: **0 464 640 A2**

# EUROPÄISCHE PATENTANMELDUNG

(21) Anmeldenummer: 91110572.4

(22) Anmeldetag: 26.06.91

(51) Int. Cl.5: **B05D 1/20**

(30) Priorität: 02.07.90 DE 4021197

(43) Veröffentlichungstag der Anmeldung:
08.01.92 Patentblatt 92/02

(84) Benannte Vertragsstaaten:
**BE DE DK FR GB GR IT NL SE**

(71) Anmelder: **HOECHST AKTIENGESELLSCHAFT**
**Postfach 80 03 20**
**W-6230 Frankfurt am Main 80(DE)**

(72) Erfinder: **Riegler, Hans, Dr.**
**Biebricher Allee 50**
**W-6200 Wiesbaden(DE)**
Erfinder: **Spratte, Karl**
**Bgm. Wiedemaier Strasse 3**
**W-6906 Leimen(DE)**

(54) **Verfahren zur Herstellung hochreiner, homogener, monomolekularer, ultradünner Schichten auf festen Trägern.**

(57) Verfahren zur Herstellung hochreiner homogener monomolekularer Schichten nach dem Langmuir-Blodgett-Verfahren. Am Meniskusende auftretende Verunreinigungskonzentrationen werden parallel zur Dreiphasenlinie beispielsweise durch eine kontrollierte laterale, lokale Strömung eines Gases über die Wasseroberfläche oder Verdünnung der schwimmenden Monoschicht durch Expansion abtransportiert. Der Abtransport der Verunreinigungen kann simultan während des Übertrags aufrechterhalten werden.

EP 0 464 640 A2

Die Erfindung bezieht sich auf ein Verfahren zur Herstellung hochreiner, homogener, monomolekularer Schichten auf festen Trägern nach dem Langmuir-Blodgett-Verfahren, bei dem während des Übertragungsprozesses auftretende Verunreinigungsanreicherungen durch eine gezielte und kontrollierte, laterale, lokale Oberflächenkonvektion oder durch gezielte, Kompressions-Expansionszyklen wegtransportiert bzw. verdünnt werden.

Beschichtete Träger finden in der industriellen Technik in zunehmendem Maße Verwendung.

So können nach dem LB-Verfahren beschichtete Träger beispielsweise für die Kommunikationstechnik als elektronische und optoelektronische aktive Bauelemente eingesetzt werden. Die Schichten sind auch geeignet als aktive Elemente oder passive Matrix im Bereich der Sensorik. Weiterhin können die mechanischen oder chemischen Oberflächeneigenschaften von Substraten durch Beschichtung von deren Oberfläche einem gewünschten Zweck angepaßt werden, beispielsweise zur Reibungsverminderung. Die Schichten können aber auch als Schutzfilme für die darunterliegende Trägeroberfläche dienen, um deren besondere Oberflächeneigenschaften zu konservieren.

Für diese Anwendungen ist es erforderlich, wohldefinierte, ultradünne, zum Teil auch mehrlagige Beschichtungen von hoher Reinheit, Defektarmut und Homogenität herzustellen.

Homogene, verunreinigungsarme und möglichst defektfreie, ultradünne, organische, geordnete Schichten und Schichtsysteme sind z.B. im Einzelnen für folgende Anwendungen von großem Interesse:

a) Optische Anwendungen: gerichtete, geleitete Strahlungsführung mit geringen Dämpfungsverlusten infolge Absorption oder Lichtstreuung, wie z.B. Lichtwellenleiter mit nichtlinear-optischen Eigenschaften.

b) Elektrische Anwendungen: elektrische Leiter hoher Anisotropie, z.B. eindimensionale oder zweidimensionale Leiter (beispielsweise Molekularelektronik).

c) Aktive Elemente oder "Wirtsgitter" für den definierten Einbau von Sensorelementen im Bereich der Sensorik (z.B. pyroelektronische Detektoren niedrigster Wärmekapazität oder hochspezifische Biosensoren auf der Basis selektiver Oberflächenbindung funktioneller Gruppen oder Moleküle).

d) Schutzfilme als Oberflächenbarriere gegen chemische, mechanische, oder elektrische Einwirkungen (z.B. Lubrikationsfilme, Korrosionsschutz, isolierende Schichten).

Zur Herstellung von geordneten, ultradünnen organischen Schichten und Schichtsystemen wird vorzugsweise das Langmuir-Blodgett (LB)-Verfahren benutzt. Bei diesem. Verfahren werden geeignete Moleküle auf einer Wasseroberfläche gespreitet. Durch die Veränderung der Fläche pro Molekül infolge Veränderung der Gesamtoberfläche läßt sich die Packungsdichte bzw. Struktur und Orientierung der Moleküle bestimmen. Typischerweise wird dann die schwimmende, monomolekulare Schicht bei einer konstantgehaltenen Fläche pro Molekül durch Ein- oder/und Austauchen eines festen Substrats auf dieses übertragen. Pro Tauchgang wird dabei eine monomolekulare Schicht auf den Träger übertragen. Durch wiederholtes Ein- und Austauchen des gleichen Trägers lassen sich damit auch Vielfachschichtsysteme aufbauen.

Für den Aufbau von LB-Filmen verwendet man hauptsächlich wasserunlösliche amphiphile Moleküle. Diese Moleküle besitzen ein hydrophiles Ende ("Kopf") und ein hydrophobes Ende ("Kette") und ordnen sich auf der Wasseroberfläche mit der hydrophilen Seite zur Wassersubphase. Neben amphiphilen Monomeren eignen sich auch amphiphile Polymere und langkettige, rein hydrophobe Moleküle zum Aufbau von LB-Schichten.

Die Herstellung von dünnen Schichten mittels der LB-Technik wurde bereits mehrfach beschrieben (DE-A 3 843 194; DE-A 3 911 929).

Ein zentrales Problem bei der Herstellung und Verwendung von LB-Filmen stellt die Reinheit und Homogenität der Schichten dar.

Beim Übertragen der auf der Wasseroberfläche gespreiteten Monoschicht auf den festen Träger läßt sich beobachten, daß es zu einer selektiv stärkeren attraktiven Schicht/Substrat-Wechselwirkung zwischen den dichter gepackten, kondensierten Bereichen der Monoschicht im Vergleich zur flüssigen, weniger geordneten Matrix der Monoschicht kommt. Diese selektive Wechselwirkung äußert sich beispielsweise in der direkt beobachtbaren selektiven Anziehung der schwimmenden Domänen von Koexistenzphasen durch das feste Substrat. Weiterhin läßt sich beobachten, daß der Träger als Nukleations- und Kondensationsfläche für die Monoschichtmoleküle wirkt, d.h. die Monoschicht adsorbiert bevorzugt als höher geordnete, kondensierte Matrix auf den Träger.

Die selektive Wechselwirkung der kondensierten schwimmenden Domänen bzw. die Kondensation der Monoschicht im Moment des Übertrags führt zu Beginn des LB-Übertrags (Anfang des Herausziehens des Trägers) zunächst zur Übertragung einer verunreinigungsarmen, kondensierten Schicht, bei gleichzeitiger Anreicherung von Verunreinigungen in der noch schwimmenden, flüssigen Schichtzone direkt an der Dreiphasen-Grenzlinie (d.h. der Stelle, wo die Monoschicht den Träger berührt). Diese Phasenseparation ist eine Folge der Schichtkondensation bzw. selektiven Attraktion der kondensierten Domänen. Die kondensierten Bereiche sind wesentlich höher geordnet als die flüssigeren Bereiche und enthalten erheblich weniger Verunreinigungen, da diese die Ordnung stören. Die Selektion der reineren Substanz für den Übertrag führt zu einem Anstieg der Verunreinigungskonzentration am Ende des Meniskus in der noch schwimmenden, noch nicht übertragenen Monoschicht. Nach einer anfänglich zunehmenden Phasenseparation, die durch den Übertrag der reineren Substanz auf den Träger und das Ansteigen der Verunreinigungskonzentration in der noch schwimmenden Grenzzone hervorgerufen wird, stellt sich schnell ein (dynamisches) Gleichgewicht ein. Diese Gleichgewichtssituation hinsichtlich der lokalen Verunreinigungskonzentration und deren Profil wird durch mehrere Faktoren, wie z.B. Temperatur und Übertragungsgeschwindigkeit bestimmt. Ein Gleichgewicht stellt sich deshalb ein, weil mit steigender Verunreinigungskonzentration während des Übertrags zwangsläufig der Punkt erreicht wird, wo die Selektivität der Substrat/Schicht-Wechselwirkung für die kondensierte Matrix nicht mehr ausreicht und Verunreinigungen mit übertragen werden. Aus Gründen der Substanzerhaltung wird damit letztendlich beim dynamischen Gleichgewicht eine Schicht mit der gleichen Verunreinigungskonzentration wie der des schwimmenden Films übertragen. Dies ist die typische Situation beim heutzutage üblichen LB-Übertrag. Die Verunreinigungszone ist deshalb lokalisiert, weil der Abtransport (Verdünnung) der Verunreinigungen am Meniskusende wegen fehlender Konvektion nur diffusionskontrolliert und daher für sinnvolle Übertragungsgeschwindigkeiten praktisch wirkungslos ist.

Der Aufbau und die Stabilisierung der höheren Verunreinigungskonzentration am Meniskusende läßt sich durch die Erhöhung des Verfestigungsdruckes (Raoult'sches Gesetz) und damit als domänenverarmte bzw. domänenfreie Zone am Meniskusende direkt beobachten. Die zu übertragende Monoschicht wird immer kurz vor dem Übertrag auf das feste Substrat durch die Verunreinigungszone geschoben und dabei den Bedingungen höherer Verunreinigungskonzentration ausgesetzt.

In der Literatur wurden bislang kaum Verfahren zur direkten gezielten Veränderung der zu übertragenden Schicht durch Substrat/Schicht-Wechselwirkungen beschrieben. Die meisten angegebenen Verfahren beziehen sich auf die Veränderung der Schichteigenschaften des noch auf der ebenen Wasseroberfläche schwimmenden Films.

Ein Verfahren (Thin Solid Films, 179 (1989) 233-238) beschreibt die elektrochemische Modifikation von Filmen während des LB-Übertrags. Durch eine niedrige angelegte Spannung (< 1 Volt) zwischen dem Substrat und der Subphase wird dabei die zu übertragende Monoschicht während des Übertrags elektrochemisch oxidiert bzw. reduziert.

Die beschriebenen Experimente beschränken sich auf die elektrochemische Modifikation der Moleküle und deren Auswirkungen auf die Schichtstruktur. Physikalische Schichtmodifikation werden dabei ausschließlich auf die chemische Veränderung der Schichtmoleküle zurückgeführt.

Ein anderes Verfahren (Thin Solid Films, 178 (1989) 183-189) beschreibt die Herstellung verunreinigungsarmer Monoschichten mittels lokalen Aufschmelzens auf der Wasseroberfläche. Die Monoschicht wird mittels einer lokalen Wärmequelle (z.B. Heizstab) bei konstantem Oberflächendruck lokal erhitzt, d.h. geschmolzen, und anschließend wieder abgekühlt (kondensiert). Durch die Umkristallisation werden die Verunreinigungen aus der geordneten Phase gedrängt. Hierbei wird ein Heizstab langsam in geeignetem Abstand über die Monoschicht bewegt, wodurch es zu einem lokalen Aufschmelzen und anschließender Rekristallisation kommt.

Ein weiteres Verfahren (DE-A-4 010 201) benutzt die bei bestimmten Kompressions/Expansions-zyklen verursachte Defektausheilung zur Herstellung von fehlstellenarmen Monoschichten auf dem Wasser.

Die beschriebenen Verfahren zur physikalisch-strukturellen Schichtmodifikation beschränken sich auf die Verbesserung von Monoschichten auf der Wasseroberfläche. Untersuchungen zeigen jedoch, daß sich die Schichteigenschaften (Homogenität, Defektdichte, Reinheit usw.) während des Übertrags signifikant ändern. Da praktisch alle technischen Anwendungen den Einsatz dünner organischer Schichten auf festen Trägern voraussetzen, ist letztendlich die Qualität der übertragenden Schichten ausschlaggebend. Diese ist bei dem bislang üblichen Standard-LB-Übertrag (kontinuierlicher Übertrag bei fest eingestellten Parametern wie Druck, Temperatur, Übertragungsgeschwindigkeit, usw.) keinesfalls zufriedenstellend hinsichtlich Homogenität und Defektarmut. So läßt sich bei Substanzen mit Phasenübergängen erster Ordnung keine geschlossene kondensierte Matrix übertragen. Es kommt bereits bei der Kompression auf dem Wasser zur Domänenbildung mit geordneten, reinen Bereichen in einer flüssigen, höher verunreinigten Matrix. Diese Strukturen werden beim Übertrag infolge der Schicht/Substrat-Wechselwirkungen weiter verändert, so daß insgesamt ein ausgeprägt heterogener Film übertragen wird.

Es bestand daher die Aufgabe, ein Verfahren zu entwickeln, mit dem es möglich ist, hochreine, defektarme, monomolekulare Schichten nach dem LB-Verfahren auf festen Trägern zu erhalten.

Diese Aufgabe wird durch das erfindungsgemäße Verfahren gelöst, bei dem hochreine homogene monomolekulare ultradünne Schichten nach dem Langmuir-Blodgett Verfahren hergestellt werden, indem die am Meniskusende auftretende Verunreinigungskonzentration, die ein Übertragen einer hochgeordneten, hochreinen Matrix verhindert, parallel zur Dreiphasenlinie oberflächenkonvektiv abtransportiert wird.

Der Abtransport der Verunreinigungen am Meniskusende kann in einem bevorzugten Fall durch ein kontrolliertes Vorbeiströmen (z.B. seitliche laminare Strömung) eines geeigneten Gases über die Wasseroberfläche erfolgen. Derartige geeignete Gase stellen beispielsweise die Edelgase aber auch Stickstoff und Luft dar. Ein besonderer Vorteil dieses Verfahrens liegt in der Möglichkeit den Abtransport der Verunreinigungen simultan während des Übertrages aufrechtzuerhalten, so daß eine kontinuierliche Arbeitsweise gewährleistet ist.

Der Abtransport der Verunreinigungen am Meniskusende kann in einem weiteren bevorzugten Fall auch durch geeignete Kompressions/Expansionszyklen bewirkt bzw. verstärkt werden. Typischerweise wird dabei die Schicht solange durch Austauchen des Trägers auf diesen übertragen, bis infolge der stetig zunehmenden Verunreinigungskonzentration am Meniskusende die Gefahr eines verunreinigten Übertrags besteht. Bevor dies eintritt wird der Übertrag der Monoschicht angehalten und der schwimmende Film expandiert. Dabei kommt es zu einer Verdünnung der auf dem Wasser schwimmenden Monoschicht und zur Entfernung der Verunreinigungen am Meniskusende. Sodann kann nach Rekompression wieder ein Stück hochwertiger Schicht auf den Träger übertragen werden. Dadurch ergibt sich bei geeignetem Vorgehen eine nahtlose, homogene, hochreine, kondensierte Schicht.

Insbesondere vorteilhaft ist es, wenn die beschichtete Fläche des Trägers vor der Filmexpansion bis unter die Gleichgewichtshöhe des Meniskus abgesenkt wird. Auf diese Weise wird vermieden, daß es während der Expansion bzw. Rekompression zu einer unerwünschten unkontrollierten Beschichtung (Druckbeschichtung) des Trägers mit der verunreinigungsreichen Schicht kommt.

Eine typische Beschichtungssequenz zur Herstellung einer kontinuierlichen, homogenen, hochreinen Beschichtung verläuft wie folgt:

1. Langsames Beschichten (Beschichtungsdruck $\pi$ = konstant) unter Beobachtung der Zunahme der Verunreinigungskonzentration am Meniskusende.

2. Stop der Beschichtung durch Anhalten des Trägeraustauchens.

3. Wiedereintauchen des Trägers bei $\pi$ = konstant. Das Meniskusende bleibt dabei auf dem Träger festgelegt, bewegt sich aber relativ zur Subphase, d.h. das Meniskusprofil wird geändert. Nach einer Absenkung der Meniskushöhe (= Höhe des Meniskusendes relativ zur ebenen Subphasenoberfläche) von mehreren 100 $\mu$m wird der Träger angehalten.

4. Die schwimmende Monoschicht wird voll expandiert. Dabei werden die Verunreinigungen am Meniskusende wegtransportiert und verdünnt.

5. Die Monoschicht wird wieder auf Übertragungsdruck komprimiert.

6. Der Träger wird (langsam) ausgetaucht, es kommt ab der geeigneten Meniskushöhe (Gleichgewichtshöhe) zu der gewünschten homogenen und hochreinen Beschichtung bei gleichzeitiger Verunreinigungsanreicherung im schwimmenden Meniskusende. Der Beschichtungsvorgang wiederholt sich nun wieder ab Punkt 1.

Um eine wirksame Selektion der höhergeordneten Schichtfragmente am Meniskusende zu gewährleisten, ist eine vergleichsweise langsame Beschichtungsgeschwindigkeit (< 10 $\mu$m/sec) vorteilhaft.

Das erfindungsgemäße Verfahren basiert auf dem Unterschied in der Dipoldichte von verschiedenen Monoschichtbereichen. Bei heterogenen Filmen (d.h. beispielsweise bei verunreinigten oder gezielt dotierten Filmen) lassen sich praktisch immer lokale Phasenseparationen einstellen z.B. über den Druck oder die Temperatur, die dann infolge ihrer unterschiedlichen Dipoldichte beim Übertrag selektiert werden können. Das erfindungsgemäße Verfahren ist daher auf viele verschiedene Substanzen anwendbar.

Die mit dem erfindungsgemäßen Verfahren hergestellten monomolekularen Schichten zeichnen sich durch eine hohe Reinheit und eine hohe laterale strukturelle Homogenität aus. Ein besonderer Vorteil liegt in der Möglichkeit den Reinheitsgrad oder auch den Dotierungsgrad der Schichten gezielt einstellen zu können.

**Beispiele**

Dipalmitoylphosphatidylcholin-Monoschichten wurden nach dem erfindungsgemäßen Verfahren hergestellt. Die Schichten wurden zunächst nach dem Standard-LB-Verfahren aufgezogen wobei die beschriebenen selektiven Substrat/Schicht-Wechselwirkungen beobachtet wurden. Nach einer anfänglichen Beschichtung mit einer verunreinigungsarmen Zone (< 50 $\mu$m breit) steigt der Verunreinigungsgehalt am Meniskusende so stark an, daß die Schicht inhomogen und verunreinigt übertragen wird. Als Indikator für die Verunreinigung dient dabei ein in geringen Mengen (< 1 mol-%) zugesetzter Fluoreszenzfarbstoff, der selbst als Verunreinigung wirkt und mittels eines geeigneten Transfer-Fluoreszenzmikroskops lokalisiert werden kann. Die nach dem üblichen LB-Verfahren hergestellten Schichten zeigen eine heterogene Struktur.

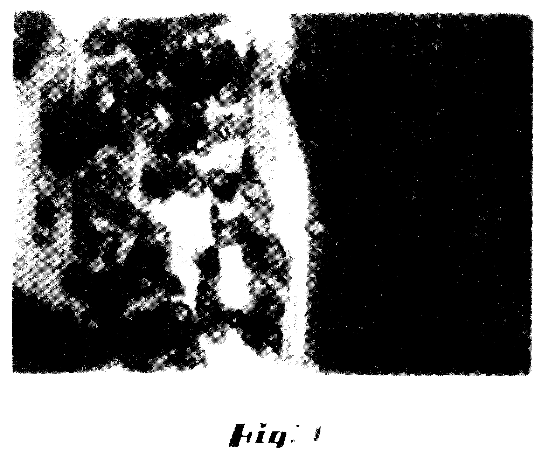

Das Ergebnis einer kontinuierlichen langsamen Beschichtung unter konvektivem Verunreinigungstransport ist in Fig. 1 gezeigt. Der Träger wurde zunächst langsam ohne Konvektion ausgetaucht. Dabei wird der helle, verunreinigungsreiche, heterogene Bereich übertragen (linke Hälfte, Fig.1). Dann wurde, ohne das Austauchen zu unterbrechen, ein konstanter Argonfluß eingestellt, der den Verunreinigungsabtransport bewirkt. Die damit übertragene Schicht ist in Fig. 1 auf der rechten Seite abgebildet. Es ist ersichtlich, daß die konvektiv präparierte Schicht deutlich weniger Farbstoff ( = weniger Verunreinigungen) enthält, als die unter sonst gleichen Bedingungen aber ohne gezielte Konvektion aufgezogene Schicht. Die Schicht ist wesentlich verunreinigungsärmer und auch homogener.

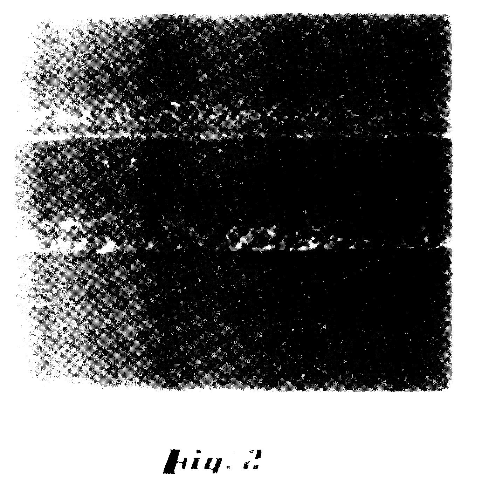

Fig. 2 demonstriert die Durchführung einer sequentiellen, möglichst homogenen und verunreinigungsarmen Beschichtung mittels geeigneter Kompressions/Expansions- und Eintauch/Austauch-Zyklen zum Wegtransport der angesammelten Verunreinigungen. Es ist ersichtlich, wie sich kontinuierliche, homogene, verunreinigungsarme (dunkle) Zonen verschiedener Breite beschichten lassen (untere Hälfte von Fig. 2). Die breitere der drei dunklen Zonen setzt sich aus zwei aufeinanderfolgenden Beschichtungssequenzen zusammen und soll demonstrieren, daß sich durch geeignete stückweise Beschichtungszyklen beliebig lange, kontinuierliche, homogene, hochreine Monoschichten übertragen lassen. Die zwischen den drei dunklen Zonen auftretenden hellen, heterogenen Bereiche entstehen bei ungenügendem Abtransport der sich ansammelnden Verunreinigungen (hier Fluoreszenzfarbstoff). Die aufgelisteten Versuche zur Verbesserung der Schichtqualität von DPPC-Monoschichten wurden auch an Dimyristoylphosphatidyläthanolamin- (DMPE-) Filmen durchgeführt. Für dieses Material wurde die gleiche Selektivität der Substrat/Schicht-Wechselwirkung bezüglich der Molekülpackungsdichte bzw. -Orientierung beobachtet.

**Patentansprüche**

1. Verfahren zur Herstellung hochreiner homogener monomolekularer Schichten nach dem Langmuir-Blodgett-Verfahren, dadurch gekennzeichnet, daß am Meniskusende auftretende Verunreinigungskonzentrationen parallel zur Dreiphasenlinie oberflächenkonvektiv abtransportiert werden.

2. Verfahren nach Anspruch 1, dadurch gekennzeichnet, daß die Verunreinigungen durch eine kontrollierte, laterale, lokale Strömung eines Gases über die Wasseroberfläche abtranstiert werden.

3. Verfahren nach Anspruch 2, dadurch gekennzeichnet, daß das Gas ein Edelgas, Stickstoff oder Luft ist.

4. Verfahren nach Anspruch 1, dadurch gekennzeichnet, daß der Abtransport der Verunreinigungen simultan während des Übertrags aufrechterhalten wird.

5. Verfahren zur Herstellung hochreiner, homogener monomolekularer Schichten nach dem Langmuir-Blodgett-Verfahren, dadurch gekennzeichnet, daß die am Meniskusende auftretende Verunreinigungskonzentration durch die Expansion der schwimmenden Monoschicht verdünnt und abtransportiert wird.

6. Verfahren nach Anspruch 5, dadurch gekennzeichnet, daß der Abtransport der Verunreinigungen sequentiell während geeigneter Eintauch/Austauch- und Kompressions/Expansions-Zyklen bewirkt wird, und die beschichtete Fläche des Trägers vor der Filmexpansion bis unter die Gleichgewichtshöhe des Meniskus abgesenkt wird.

**Fig. 1**

Fig: 2